**Europäisches Patentamt**

**European Patent Office**

**Office européen des brevets**

(19)

(11) Numéro de publication: **0 073 700**
**A1**

(12) # DEMANDE DE BREVET EUROPEEN

(21) Numéro de dépôt: **82401463.3**

(22) Date de dépôt: **03.08.82**

(51) Int. Cl.³: **H 03 K 19/094**

(30) Priorité: **21.08.81 FR 8116113**

(43) Date de publication de la demande: **09.03.83**
**Bulletin 83/10**

(84) Etats contractants désignés: **DE GB IT SE**

(71) Demandeur: **THOMSON-CSF, 173, Boulevard Haussmann, F-75379 Paris Cedex 08 (FR)**

(72) Inventeur: **Pham, Ngu Tung, THOMSON-CSF SCPI 173, bld Haussmann, F-75379 Paris Cedex 08 (FR)**

(74) Mandataire: **Lepercque, Jean et al, THOMSON-CSF SCPI 173, Bld Haussmann, F-75379 Paris Cedex 08 (FR)**

(54) **Circuit logique à grande entrance utilisant au moins un transistor à effet de champ à faible tension de seuil.**

(57) L'invention concerne la réalisation de circuits intégrés logiques utilisant des transistors à effet de champ à faible tension de seuil, dits «quasi-normalement bloqués», permettant d'assurer des fonctions logiques avec une grande entrance.

Un circuit ainsi réalisé comporte au moins un étage d'entrée. Cet étage d'entrée, situé entre la tension d'alimentation et la masse, est composé d'une résistance saturable $(Z_1)$ en série avec au moins un transistor $(T_1)$ du type précité, une diode $(D_1)$ de contre-réaction polarisée dans le sens passant du potentiel d'alimentation vers la masse étant insérée entre la source du transistor $(T_1)$ et la masse.

Application à la logique à transistors à effet de champ sur substrat en arséniure de gallium.

# CIRCUIT LOGIQUE A GRANDE ENTRANCE UTILISANT AU MOINS
## UN TRANSISTOR A EFFET DE CHAMP A FAIBLE TENSION DE SEUIL

L'invention vise à améliorer l'entrance de circuits logiques utilisant des transistors à effet de champ du type dit "MESFET quasi-normallement bloqués", c'est à dire à rendre ces circuits susceptibles d'être commandés simultanément par un grand nombre d'entrées, appelé entrance, sans diminution de la sécurité de fonctionnement, même en présence de bruit.

On sait réaliser sur des substrats semi-isolants des circuits intégrés logiques à très haute vitesse de commutation mais celle-ci est souvent obtenue au détriment de la consommation.

A l'heure actuelle tous les circuits sur Arséniure de Gallium sont réalisés à partir de transistors à effet de champ à jonction dits "JFET" ou à grille Schottky dits "MESFET".

Les transistors sont de deux types : les transistors "normalement conducteurs", dans lesquels le courant drain-source est bloqué par pincement du canal normalement existant (transistors à déplétion) par application d'une tension appropriée, et les transistors "normalement bloqués", dans lesquels le canal est ouvert par une tension de grille appropriée, (transistors à enrichissement).

Les premiers de ces transistors présentent l'inconvénient d'une forte consommation. De plus, les polarités des tensions d'entrée $V_{GS}$ (ou différence de potentiel grille-source) et de sortie $V_{DS}$ (différence de potentiel drain-source) sont opposées. Pour un canal de type N, la tension de blocage est négative, alors que la tension d'alimentation est positive. Il en résulte qu'il doit y avoir deux sources d'alimentation.

Dans les transistors du second type, il faut maîtriser la valeur de la tension de seuil, tension minimale de déblocage et donc du dopage et de l'épaisseur de la zone active (zone où se forme le canal). La réalisation est très délicate et les déchets de fabrication très importants.

Une troisième catégorie de transistors à effet de champ, qui est intermédiaire entre les deux précédentes tout en se rapprochant de la deuxième, est constituée par les transistors dits "quasi-normalement bloqués" : ils sont bloqués pour une tension de seuil $V_T$ qui peut être positive ou négative, ce qui signifie que l'on admet une certaine dispersion dans la fabrication collective de ces transistors qui est par exemple la suivante :

$$- 0,4 \leq V_T \leq 0,2 \text{ volt.}$$

Ce qui permet de réaliser sur un substrat en arséniure de gallium des circuits logiques intégrés à grande densité d'intégration (plus de 200 portes par millimètre carré), à très grande vitesse de réponse (temps de propagation de 100 à 200 picosecondes par opérateur), à faible consommation (quelques centaines de microwatts par opérateur), tout en assurant un très grand rendement de fabrication.

Ainsi cette dernière catégorie est plus facile à fabriquer que la deuxième, mais plus difficile à utiliser. On sait réaliser, notamment par la technique exposée dans la demande de brevet européen publiée sous le N° 0 021 858, des transistors à faible tension de seuil et un inverseur logique réalisé à base de transistors de ce type. Dans cette technique, on creuse, par érosion ionique, une tranchée entre la source et le drain, ce qui constitue une résistance saturable à très faible consommation, que l'on peut transformer en transistor à effet de champ en déposant une métallisation dans le fond de la tranchée à l'emplacement de la grille de commande et pour en remplir la fonction. Toutefois, les transistors réalisés par cette technologie présentent une certaine dispersion, et en raison de la dispersion des caractéristiques, la tension de seuil est tantôt positive, tantôt négative ; dans le cas où elle est négative, le transistor d'entrée n'est pas bloqué, ce qui présente, une diminution d'entrance, interdisant notamment la constitution d'entrées multiples.

La présente demande de brevet est relative à des circuits logiques de ce type à base de transistors à effet de champ "MESFET" "quasi-normalement bloqués", à tension de seuil faiblement négative.

L'avantage de cette nouvelle logique est sa très grande tolérance sur les variations de la tension de seuil : $V_T$ peut être comprise entre + 200 et - 600 millivolts. Ce qui assure un très bon rendement de fabrication. Le rendement est d'autant meilleur que la tension de seuil est plus négative. Cependant, avec des transistors à effet de champ "MESFET" à tension de seuil faiblement négative, les portes NON-OU de cette nouvelle logique sont limitées en nombre d'entrées (Entrance inférieure à 3).

Pour augmenter l'entrance $N_{IN}$, il est essentiel de bloquer complètement les transistors à effet de champ "MESFET" d'entrée, rendant les courants résiduels nuls.

La présente demande de brevet se fixe pour but de répondre à ce besoin.

L'invention a pour objet un circuit logique utilisant au moins un transistor à effet de champ à faible tension de seuil connecté entre une première et une deuxième borne d'un générateur de tension d'alimentation comprenant :

- au moins un étage d'entrée comportant en série au moins un transistor à effet de champ dont la grille qui constitue la borne d'entrée reçoit la tension logique d'entrée, sa source étant connectée à la deuxième borne du générateur de tension d'alimentation, son drain étant connecté par une résistance saturable à la première borne de ce générateur de tension ;

- un étage de sortie comportant en série au moins une diode polarisée dans le sens passant et une résistance saturable, reliée à la deuxième borne du générateur de tension d'alimentation, dont la valeur est inférieure à l'impédance de la diode dans le sens passant, celle-ci fonctionnant dans un des états du circuit dans la partie non linéaire de sa caractéristique, la deuxième extrémité de cette résistance étant la borne de sortie ;

- au moins un étage intermédiaire relié d'un côté à la borne de la résistance saturable de l'étage d'entrée non reliée à la première borne du générateur de la tension d'alimentation, et de l'autre à la diode de l'étage de sortie, caractérisé en ce qu'une diode de contre-réaction polarisée dans le sens passant est insérée dans l'étage d'entrée entre la source du transistor à effet de champ et la deuxième borne du générateur de tension d'alimentation, et en ce que l'étage de sortie comporte deux diodes polarisées dans le sens passant en série avec la résistance saturable.

L'invention sera mieux comprise, et d'autres caractéristiques apparaîtront, au moyen de la description qui suit et des dessins qui l'accompagnent, parmi lesquels :

- les figures 1 et 2 représentent deux circuits logiques de l'art connu ;

- la figure 3 représente un circuit logique selon l'invention ;

- les figure 4 à 9 représentent d'autres circuits logiques selon l'invention.

Dans la suite on considère des circuits branchés entre les deux bornes d'un générateur de tension d'alimentation : par convention la première borne étant + V, et la seconde étant la masse ;les transistors à effet de champ représentés ayant un canal de type N. Avec un canal de type P, ce qui est tout aussi possible, il faudrait inverser les bornes du générateur de tension d'alimentation.

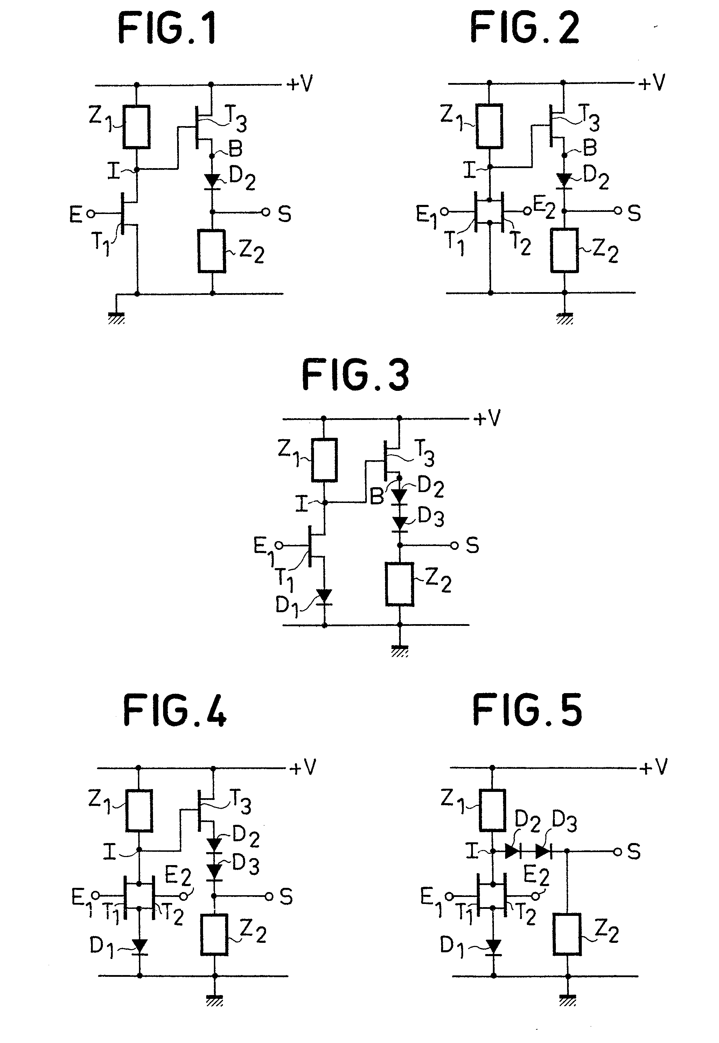

Sur la figure 1 est représenté un inverseur logique de l'art connu dont l'entrée logique E est connectée à la grille d'un transistor $T_1$, dont la source est à la masse, le drain connecté à un point I, lui-même connecté à la source d'alimentation V par une résistance $Z_1$.

Le transistor $T_1$ est un transistor à effet de champ de type "MESFET" "quasi-normalement bloqué" et $Z_1$ une résistance saturable.

Le point I est relié à la grille d'un transistor $T_3$ identique au précédent ; ce transistor a son drain connecté à + V, sa source B a une diode $D_2$ passante de + V à la masse, l'autre borne de la diode $D_2$ est connectée à la masse par une résistance saturable $Z_2$.

Tout d'abord il faut souligner qu'un paramètre important des transistors à effet de champ décrits est celui de la tension de déchet $V_{déchet}$ qui est la tension drain-source résiduelle quand le transistor est à l'état passant.

Dans les circuits connus, le blocage d'un transistor d'entrée d'un circuit logique ne peut être réalisé que si $V_T \gtrsim V_{déchet}$.

Ces circuits ne peuvent donc être réalisables qu'avec des seuils nettement positifs de l'ordre de 0,2 V : soit de 150 à 250 mV. Dans les circuits considérés cette condition n'existe plus.

Lorsque l'entrée E est à la masse, état "0", le transistor $T_1$ est semi-bloqué, le potentiel au point I est voisin de + V, la jonction grille-source du transistor $T_3$ est polarisée en direct, le potentiel au point B (source du transistor $T_3$) tend à monter à + V. Le potentiel de la sortie S ne peut pas monter au-dessus de 0,8 V, du fait qu'il est connecté à la porte d'entrée de l'étage suivant, et que la chute de tension aux bornes de la jonction grille-source de la porte d'entrée de l'étage suivant, qui dans ce cas est passante, est de l'ordre de 0,8 V.

La tension $V_D$ aux bornes de la diode $D_2$ qui est passante est également de l'ordre de 0,8 V. Le courant de sortie est limité par la résistance $Z_2$.

Lorsque la grille du transistor $T_1$ est portée au niveau "1" qui est limité par la polarisation en direct de la jonction grille-source (sensiblement 0,8 Volts), le potentiel au point I est la tension $V_{déchet}$ du transistor $T_1$ qui est passant.

Ceci tend à bloquer le transistor $T_3$ ; le courant dans l'ensemble $T_3$ - $D_2$ - $Z_2$ restera très faible.

La sortie S est prise en pont entre la diode $D_2$ et la résistance $Z_2$. Or la résistance $Z_2$ a une valeur très faible, et la résistance de la diode pour un courant très faible dans le sens passant appliqué entre ses bornes est nettement plus élevée. C'est donc la diode qui prend en compte tout le potentiel résiduel entre B et la masse ; la sortie S a donc sa sortie calée sur la masse.

Du fait de la caractéristique très non-linéaire de la diode au voisinage de sa tension de coude, il suffit d'un courant très faible dans l'ensemble $T_3$ - $D_2$ - $Z_2$ pour que cet effet se produise.

Il en résulte que dans l'inverseur considéré, la condition $V_T$ très voisin de 0 mais essentiellement positif n'est plus nécessaire et qu'il suffira que l'inégalité $V_T \gtrsim V_{déchet} - V_{Do}$ soit respectée, $V_{Do}$ étant la valeur de la tension de coude de la diode $D_2$. $V_T$ pourra même être négatif puisque la tension de coude de la diode est voisine de 0,5 V. $V_T$ pourra être supérieur non pas à $V_{déchet}$ mais à - 0,3 V.

Avec plusieurs diodes en série, deux par exemple, on arriverait à des résultats tels que $V_T > - 0,8$ V.

Ainsi la diode $D_2$, quoique toujours polarisée en direct, permet d'augmenter la gamme des tensions de seuil vers des valeurs faibles et même négatives, et cale la sortie au niveau bas ; la tension de déchet des transistors n'étant plus déterminante.

La figure 2 représente un circuit logique de l'art connu de fonctionnement similaire à celui de la figure 1. On a introduit un deuxième transistor $T_2$ monté en parallèle avec le transistor $T_1$ ce qui permet de réaliser en entrée une fonction OU. Cette porte est donc une porte OU-NON

à deux entrées $E_1$ et $E_2$ connectées aux grilles des deux transistors $T_1$ et $T_2$, les drains étant reliés entre eux et connectés à la source $+ V$ par une résistance $Z_1$. Les autres liaisons du circuit sont les mêmes que celles du circuit représenté en figure 1.

Si on considère cette porte OU-NON à deux entrées représentées à la figure 2, les niveaux logiques $V_B$ et $V_H$ de cette porte sont :

$$V_B = 0 \text{ Volt}$$
$$V_H = V_{0S}$$

avec $V_{0S} = 0.7$ Volt = tension d'ouverture d'une jonction Schottky.

La condition de fonctionnement de cette porte est :

$$N_{IN} \times i_{T_1}(0) < i_{Z_1} < i_{T_1}(V_{0S})$$

avec $N_{IN}$ = Nombre d'entrées

$i_{T_1}(0)$ = Courant résiduel des transistors à effet de champ d'entrée quand la grille est à 0.

$i_{T_1}(V_{0S})$ = Courant maximum des transistors à effet de champ d'entrée quand la grille est à $V_{0S}$.

$i_{Z_1}$ = Courant de la charge $Z_1$ de l'étage d'entrée.

Quand la tension de seuil des transistors à effet de champ est négative, les courants résiduels $N_{IN} i_{T_1}(0)$ sont importants pour un grand nombre d'entrées. Pour cette raison, cette relation est difficile à réaliser.

Ainsi avec des transistors "MESFET" "quasi-normallement bloqués" à tension de seuil faiblement négative, les portes OU-NON de cette nouvelle logique sont limitées en nombre d'entrées : l'entrance est inférieure à 3. Il en est de même des autres types de circuits par exemple dans le cas de l'inverseur décrit à la figure 1.

Comme dans le cas considérés aux figures 1 et 2, l'invention concerne des circuits logiques intégrés réalisés sur un substrat en Arséniure de Gallium (AsGa) ou tout autre matériau se prêtant à la réalisation des transistors "MESFET" de bonnes performances dont les tensions de seuil sont comprises entre $+ 200$ mV et $- 600$ mV, les circuits logiques sont réalisés avec des transistors "MESFET", des diodes Schottky, et des résistances saturables.

Les circuits logiques réalisés selon l'invention ont, comme dans les cas illustrés aux figures 1 et 2, les particularités suivantes :

- une seule alimentation de tension est utilisée ;

- les niveaux logiques sont fixes, quelle que soit la tension de seuil $V_T$ comprise entre + 200 mV et - 600 mV.

Mais à présent les transistors à effet de champ de chaque étage sont bloqués par des diodes de contre-réaction. Les niveaux logiques sont :

$V_B = 0$ Volt

$V_H = 2 V_{0S}$ ($\simeq$ 1,5 V)

$V_{0S}$ étant la tension d'une jonction Schottky, en effet si on considère que le circuit, représenté à la figure 3, est connecté à la porte d'entrée de l'étage suivant, on doit ajouter la chute de tension aux bornes de la jonction grille-source de cette porte d'entrée à la tension aux bornes de la diode de contre-réaction $D_1$ pour obtenir le niveau haut : $V_H$.

Dans ce circuit représenté à la figure 3, qui reproduit celui de la figure 1, on a introduit une diode $D_1$ de contre-réaction entre la source du transistor $T_1$ d'entrée et la masse et une deuxième diode $D_3$ entre la diode $D_2$ et la résistance $Z_2$. La diode $D_1$ permet de bloquer parfaitement le transistor $T_1$, on introduit alors la diode $D_3$ pour bloquer le transistor $T_3$.

La contre-réaction des transistors à effet de champ par ces diodes permet de bloquer ces transistors à effet de champ $T_1$ et $T_3$ malgré une tension de seuil faiblement négative.

Le transistor $T_1$ étant alors parfaitement bloqué, le courant résiduel est alors pratiquement nul, et si l'on considère la relation précédente la condition de fonctionnement de la porte on a :

$$N_{IN} \times i_{T_1} (0) \simeq 0$$

ce qui permet d'augmenter l'entrance $N_{IN}$.

Comme dans le cas considéré à la figure 1, la condition $V_T \underset{\sim}{>} V_{déchet}$ n'existe plus, mais il faut à présent tenir compte des diodes de contre-réaction $D_1$ et $D_3$ qui viennent d'être introduites.

Lorsque l'entrée E est à la masse, état "0", le transistor $T_1$ est

parfaitement bloqué, le potentiel au point I est voisin de + V, la jonction grille-source du transistor $T_3$ est polarisée en direct, le potentiel au point B (source du transistor $T_3$) tend à monter à + V. Le potentiel à la sortie S ne peut pas monter au dessus de 1,5 V, du fait qu'il est connecté à la porte d'entrée l'étage suivant, qui comporte la diode $D_1$ en contre-réaction et que la chute de tension aux bornes de la jonction grille-source de la porte d'entrée de qui dans ce cas est passante et de l'ordre de 0,8 V.

La tension $V_D$ aux bornes des diodes $D_2$ et $D_3$ qui sont passantes est également de l'ordre de 1,5 V. Le courant de sortie est limité par la résistance $Z_2$.

Lorsque la grille du transistor $T_1$ est portée au niveau "1" (1,5 V sensiblement) limité par la polarisation en direct de la jonction grille-source, par définition le potentiel au point I est la somme de la tension $V_{déchet}$ du transistor $T_1$ qui est passant et de la tension aux bornes de $D_1$. Ceci permet de bloquer le transistor $T_3$.

La sortie S est prise en pont entre la diode $D_3$ et la résistance $Z_2$. Or la résistance $Z_2$ a une valeur très faible, et la résistance des diodes $D_2$ et $D_3$ pour un courant très faible dans le sens passant appliqué entre ses bornes est nettement plus élevée. C'est donc les diodes qui prennent en compte tout le potentiel résiduel entre B et la masse ; la sortie S a donc son potentiel calé sur la masse.

Du fait de la caractéristique très non-linéaire de la diode au voisinage de sa tension de coude, il suffit d'un courant très faible dans l'ensemble $T_3$ - $D_2$ - $D_3$ - $Z_2$ pour que cet effet se produise.

Il en résulte que dans l'inverseur considéré, la condition $V_T$ très voisin de 0 mais essentiellement positif n'est plus nécessaire et qu'il suffira que l'inégalité $V_T \gtrsim V_I - 2V_{Do}$ soit respectée, $V_{Do}$ étant la valeur des tensions de coude des diodes $D_2$ et $D_3$, $V_T$ pourra même être négatif puisque la tension de coude des diodes est voisine de 0,5 V. $V_T$ pourra être supérieur non pas à $V_{déchet}$ mais à - 0.5 V.

Les figures 4 et 5 représentent deux types de portes NON-OU à deux entrées réalisées selon l'invention.

La particularité de ces deux portes est le bloquage par des diodes de contre-réaction de chaque étage : une diode pour l'étage d'entrée et deux pour l'étage de sortie.

Si la porte de charge est simulée par un transistor à effet de champ avec une diode en contre-réaction les niveaux de sortie de ces portes NON-OU sont :

$$V_B = 0 \text{ Volt}$$
$$V_H = 2V_{0S}$$

D'où, pour une tension de seuil

$$V_T \geq -800 \text{ mV}$$
$$i_{T_1}(0) = 0$$

La diode de contre-réaction bloque bien complètement les transistors d'entrée $T_1$ et $T_2$.

La table de vérité de cette porte est donnée dans le tableau I situé en fin de description.

Comme les courants résiduels sont nuls ou très faibles, le nombre de circuits d'entrée peut être très élevé.

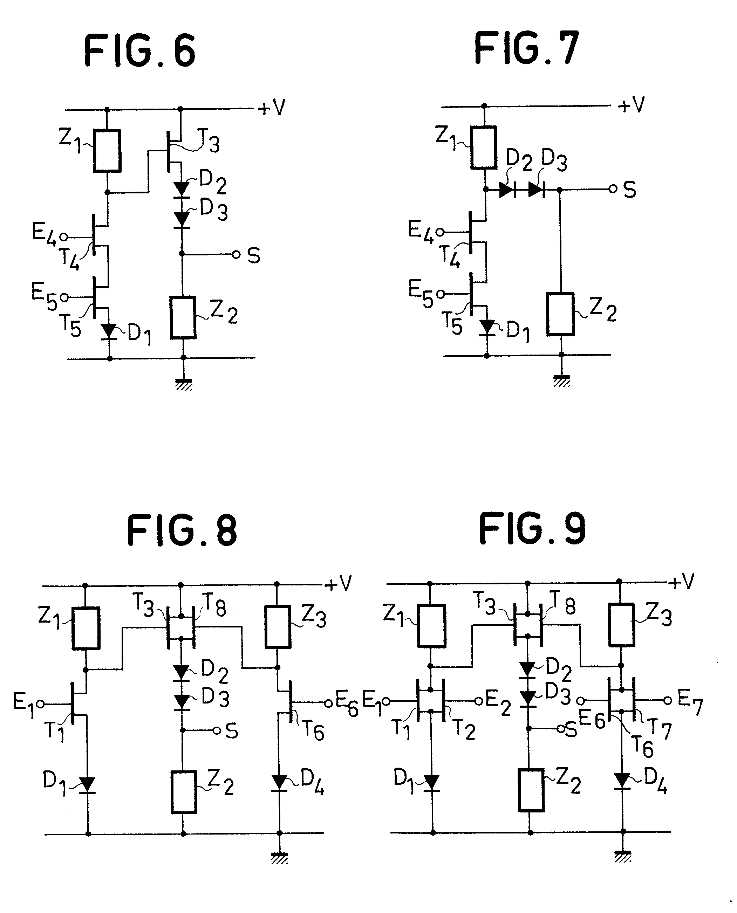

On peut réaliser des portes ET-NON en utilisant des transistors à effet de champ multi-grilles avec par exemple deux entrées $E_4$ et $E_5$ comme dans les circuits logiques classiques, avec la même contre-réaction par diode suivant les schémas des figures 6 et 7.

Les bi-grilles sont assimilés à des transistors à effet de champ en série dans la technique à canal creusé, dans ce cas, les niveaux de transfert ou tensions de basculement des grilles supérieures du côté drain sont légèrement décalés par rapport à ceux des grilles inférieures du côté source. Ce décalage peut être gênant dans les circuits décrits dans la référence, mais dans le cas des figures 6 et 7, il n'est pas important à cause de la très grande excursion de tension des niveaux logiques : $2V_{OS} \simeq 1.5$ Volt.

Dans la figure 8, on présente des nouvelles portes ET-NON de transfert identique pour chaque entrée. Il s'agit de deux inverseurs identiques dont la sortie est mise en commun ; ces inverseurs correspondent à celui de la figure 3.

Si l'une des entrées est bloquée, l'étage de sortie correspondant est débloqué et la sortie est forcée par cet étage aux niveaux hauts. Dans le cas où les deux entrées sont passants, les deux sorties sont bloquées et la sortie commune est aux niveaux bas. La table de vérité de ce circuit est donnée dans le tableau II, situé en fin de description.

L'avantage de ces portes est d'avoir les mêmes caractéristiques de transfert pour toutes les entrées.

La combinaison de deux portes OU-NON de la figure 4 donne une porte OU-NON-OU dont la fonction logique est la suivante :

$$V_S = \overline{(V_{E1} + V_{E2}) (V_{E6} + V_{E7})} = \overline{(V_{E1} + V_{E2})} + \overline{(V_{E6} + V_{E7})}$$

Cette porte représentée à la figure 9, est très utile dans les circuits logiques séquentiels comme les registres à décalage, les diviseurs de fréquence.Elle présente l'avantage sur les circuits classiques d'avoir des caractéristiques de transfert identiques pour chaque entrée.

Ainsi les portes logiques selon l'invention ont des points particuliers suivants :

Les transistors à effet de champ de chaque étage sont contre réactionnés par des diodes Schottky : une à l'étage inverseur, deux à l'étage suiveur-décaleur. Les transistors à effet de champ ont des tensions de seuil faiblement négatives : $V_T > - 600$ mV.

Les portes ET-NON réalisées par des inverseurs parallèles dont les sorties sont mises en commun ont des caractéristiques de transfert identiques pour chaque entrée, d'où une très bonne marge de bruit, et un bon rendement de fabrication.

Les niveaux de sortie sont fixes quelle que soit la tension de seuil $V_T$. L'excursion de tension est de 1.5 Volt environ.

Tous les circuits ont une alimentation de tension unique.

Avec des tensions de seuil faiblement négatives, les charges Z peuvent être remplacées par des transistors à effet de champ dont les grilles sont court-circuitée à la source.

0073700

11

## TABLEAU I

| $V_{E1}$ | $V_{E2}$ | $V_S$ | CONDITION DE FONCTIONNEMENT |
|---|---|---|---|
| 0 | 0 | $2V_{OS}$ | $i_{Z_1} > i_{E1}(0) + i_{E2}(0) = 0$ |
| $2V_{OS}$ | 0 | 0 | $I_{E1}(2V_{OS}) > i_{Z_1}$ |
| 0 | $2V_{OS}$ | 0 | $i_{E2}(2V_{OS}) > i_{Z_1}$ |
| $2V_{OS}$ | $2V_{OS}$ | 0 | $i_{E1}(2V_{OS}) + i_{E2}(2V_{OS}) > i_{Z_1}$ |

## TABLEAU II

| $V_{E1}$ | $V_{E6}$ | $V_S$ |
|---|---|---|
| $2V_{OS}$ | $2V_{OS}$ | 0 |
| $2V_{OS}$ | 0 | $2V_{OS}$ |
| 0 | $2V_{OS}$ | $2V_{OS}$ |
| 0 | 0 | $2V_{OS}$ |

REVENDICATIONS

1. Circuit logique utilisant au moins un transistor à effet de champ à faible tension de seuil connecté entre une première et une deuxième borne d'un générateur de tension d'alimentation comprenant :

- au moins un étage d'entrée comportant en série au moins un transistor à effet de champ $(T_1)$ dont la grille qui constitue la borne d'entrée (E) reçoit la tension logique d'entrée, sa source étant connectée à la deuxième borne du générateur de tension d'alimentation, son drain étant connecté par une résistance saturable $(Z_1)$ à la première borne de ce générateur de tension ;

- un étage de sortie comportant en série au moins une diode $(D_2)$ polarisée dans le sens passant et une résistance saturable $(Z_2)$, reliée à la deuxième borne du générateur de tension d'alimentation, dont la valeur est inférieure à l'impédance de la diode $(D_2)$ dans le sens passant, celle-ci fonctionnant dans un des états du circuit dans la partie non linéaire de sa caractéristique, la deuxième extrémité de cette résistance $(Z_2)$ étant la borne de sortie (S) ;

- au moins un étage intermédiaire relié d'un côté à la borne de la résistance saturable $(Z_1)$ de l'étage d'entrée non reliée à la première borne de générateur de la tension d'alimentation, et de l'autre à la diode $(D_2)$ de l'étage de sortie, caractérisé en ce qu'une diode $(D_1)$ de contre-réaction polarisée dans le sens passant est insérée dans l'étage d'entrée entre la source du transistor à effet de champ $(T_1)$ et la deuxième borne de générateur de tension d'alimentation, et en ce que l'étage de sortie comporte deux diodes $(D_2, D_3)$ polarisées dans le sens passant en série avec la résistance saturable $(Z_2)$.

2. Circuit logique selon la revendication 1, caractérisé en ce que l'étage intermédiaire est constitué par un conducteur formant une liaison directe.

3. Circuit logique selon la revendication 1, caractérisé en ce que l'étage intermédiaire comporte un transistor à effet de champ $(T_3)$ dont la grille est relié à la résistance saturable de l'étage d'entrée $(Z_1)$, la source à la diode $(D_2)$ de l'étage de sortie, et le drain à la première borne du générateur de tension d'alimentation.

4. Circuit logique selon l'une quelconque des revendications 2 ou 3, caractérisé en ce que l'étage d'entrée comporte deux transistors à effet de champ ($T_1$, $T_2$) montés en parallèle, leurs sources étant reliés ensemble, et leurs drains étant reliés ensemble, leurs grilles constituant deux bornes d'entrée ($E_1$, $E_2$).

5. Circuit logique selon l'une quelconque des revendications 2 ou 3,caractérisé en ce que l'étage d'entrée comporte deux transistors à effet de champ ($T_4$, $T_5$) montés en série le drain du premier ($T_4$) étant relié à la résistance saturable ($Z_1$), le drain du second ($T_5$) étant relié à la source du premier ($T_4$), la source du second ($T_5$) étant reliée à la diode ($D_1$) de contre-réaction, leurs grilles constituant les bornes d'entrée ($E_4$, $E_5$).

6. Circuit logique selon la revendication 3, caractérisé en ce qu'il comporte deux étages d'entrée similaires reliés tous deux à l'étage de sortie par deux étages intermédiaires similaires.

7. Circuit logique selon la revendication 4, caractérisé en ce qu'il comporte deux étages d'entrée similaires reliés tous deux à l'étage de sortie par deux étages intermédiaires similaires.

0073700

1/2

FIG.1  FIG.2

FIG.3

FIG.4  FIG.5

# FIG.6

# FIG.7

# FIG.8

# FIG.9

Office européen
des brevets

**RAPPORT DE RECHERCHE EUROPEENNE**

0073700

Numéro de la demande

EP 82 40 1463

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| D,A | EP-A-0 021 858 (THOMSON CSF) *Figures 12-15; de page 1, ligne 1 - page 2, ligne 23; de page 6, ligne 24 - page 9, ligne 32* | 1-3 | H 03 K 19/094 |
| A | IEEE JOURNAL OF SOLID STATE CIRCUITS, vol. SC-16, no. 3, juin 1981, pages 226-232, New York (USA); G.NUZILLAT et al.: "High-speed low-power logic IC's using quasi-normally-off GaAs MESFET's". *Figures 1,2,8; de page 236, colonne de gauche, ligne 1 - page 230, colonne de gauche, ligne 7* | 1-4 | |
| A | US-A-3 675 144 (ZUK) *Figure 2A; colonne 4, lignes 15-71* | 1 | DOMAINES TECHNIQUES RECHERCHES (Int. Cl. 3) H 03 K |
| A | FR-A-2 330 221 (THOMSON CSF) *Figures 1,2,3,4; de page 2, ligne 3 - page 4, ligne 16* | 1 | |
| A | FR-A-2 056 959 (IBM) *Figures 4,5; de page 4, ligne 15 - page 7, ligne 27* | 1-3 | |
| P,X | EP-A-0 053 664 (ANDRADE) *Figures 1,2; de page 3, ligne 26 - page 4, ligne 30* | 1-3 | |

Le présent rapport de recherche a été établi pour toutes les revendications

| Lieu de la recherche LA HAYE | Date d'achèvement de la recherche 29-11-1982 | Examinateur FEUER F.S. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

_____

& : membre de la même famille, document correspondant

OEB Form 1503. 03.82